# EUROPEAN PATENT APPLICATION

(11) **EP 2 076 097 A2**
(43) Date of publication of application: **01.07.2009**
(21) Application number: 08009390.9
(22) Date of filing: 21.05.2008
(51) Int. Cl.: H05K 1/00

(54) **Flexible film and display device comprising the same**

(30) Priority: 26.12.2007 KR 20070137753
(71) Applicant: LG Electronics Inc., Seoul 150-010 (KR)
(72) Inventor: Lee, Sang Gon, Chungju-si, Choongchungbuk-do 361-480 (KR); Kim, Dae Sung, Chungju-si, Choongchungbuk-do 361-480 (KR); Chang, Woo Hyuck, Chungju-si, Choongchungbuk-do 361-480 (KR)
(74) Representative: Katérle, Axel

(57) **Abstract**

A flexible film is provided. The flexible film includes a dielectric film; and a metal layer disposed on the dielectric film, wherein the ratio of the thickness of the metal layer to the thickness of the dielectric film is about 1:1.5 to 1:10. The flexible film has excellent plating, adhesive strength, thermal resistance, folding endurance and chemical resistance properties.

## Description

This application claims priority from Korean Patent Application No. 10-2007-0137753 filed on Dec. 26, 2007 in the Korean Intellectual Property Office, the disclosure of which is incorporated herein by reference in its entirety.

### BACKGROUND OF THE INVENTION

### 1. Field of the Invention

The present invention relates to a flexible film, and more particularly, to a flexible film, which includes a metal layer and a dielectric film whose thicknesses are at a ratio of 1:1.5 to 1:10 and can thus have excellent thermal resistance, excellent dimension stability and excellent tensile strength.

### 2. Description of the Related Art

With recent improvements in flat panel display technology, various types of flat panel display devices such as a liquid crystal display (LCD), a plasma display panel (PDP), and an organic light-emitting diode (OLED) have been developed. Flat panel display devices include a driving unit and a panel and display images by transmitting image signals from the driving unit to a plurality of electrodes included in the panel.

Printed circuit boards (PCBs) may be used as the driving units of flat panel display devices. That is, PCBs may apply image signals to a plurality of electrodes included in a panel and thus enable the panel to display images. The driving units of flat panel display devices may transmit image signals to a plurality of electrodes of a panel using a chip-on-glass (COG) method.

### SUMMARY OF THE INVENTION

The present invention provides a flexible film, which includes a metal layer and a dielectric film whose thicknesses have a certain ratio and can thus have excellent thermal resistance, excellent dimension stability and excellent tensile strength.

According to an aspect of the present invention, there is provided a flexible film including a dielectric film; and a metal layer disposed on the dielectric film, wherein the ratio of the thickness of the metal layer to the thickness of the dielectric film is about 1:1.5 to 1:10.

According to an aspect of the present invention, there is provided a flexible film including a dielectric film; a metal layer on the dielectric film and including circuit patterns printed thereon; and an integrated circuit (IC) chip disposed on the metal layer, wherein the ratio of the thickness of the metal layer to the thickness of the dielectric film is about 1:1.5 to 1:10 and the IC chip is connected to the circuit patterns.

According to another aspect of the present invention, there is provided a display device including a panel; a driving unit; and a flexible film disposed between the panel and the driving unit; wherein the flexible film comprises a dielectric film, a metal layer disposed on the dielectric film and comprising circuit patterns printed thereon, and an IC chip disposed on the metal layer and the ratio of the thickness of the metal layer to the thickness of the dielectric film is about 1:1.5 to 1:10.

### BRIEF DESCRIPTION OF THE DRAWINGS

The above and other features and advantages of the present invention will become more apparent by describing in detail preferred embodiments thereof with reference to the attached drawings in which:
FIGS. 1A and 1B illustrate cross-sectional views of flexible films according to embodiments of the present invention;
FIGS. 2A and 2B illustrate diagrams of a tape carrier package (TCP) comprising a flexible film according to an embodiment of the present invention;
FIGS. 3A and 3B illustrate diagrams of a chip-on-film (COF) comprising a flexible film according to an embodiment of the present invention;
FIG. 4 illustrates diagram of a display device according to an embodiment of the present invention;
FIG. 5 illustrates cross-sectional view of the display device 400 in FIG. 4; and
FIG. 6 illustrates diagram of a display device according to an embodiment of the present invention.

### DETAILED DESCRIPTION OF THE INVENTION

The present invention will hereinafter be described in detail with reference to the accompanying drawings in which exemplary embodiments of the invention are shown.

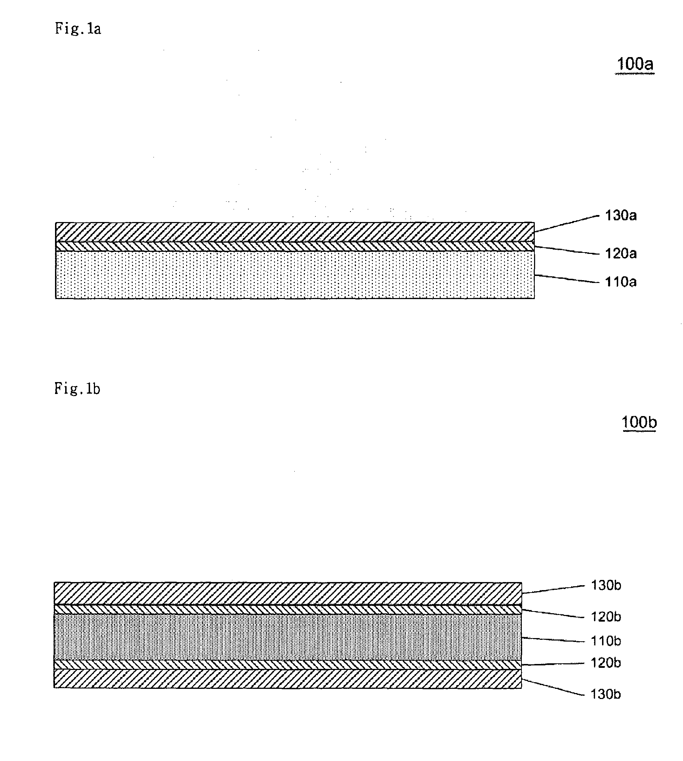

FIGS. 1A and 1B illustrate cross-sectional views of flexible films 100a through 100f, respectively, according to embodiments of the present invention. Referring to FIGS. 1A and 1B, the flexible films 100a and 100b transmit an image signal provided by a driving unit of a tape automated bonding (TAB)-type display device to an electrode on a panel of the TAB-type display device.

Referring to FIG. 1A, the flexible film 100a has a double-layer structure and is single-sided. The flexible film 100a includes a dielectric film 110a, a first metal layer 120a, which is disposed on the dielectric film 110a, and a second metal layer 130a, which is disposed on the first metal layer 120a.

Referring to FIG. 1B, the flexible film 100b has a double-layer structure and is double-sided. The flexible film 100b includes a dielectric film 110b, two first metal layers 120b, which are disposed on the top surface and the bottom surface, respectively, of the dielectric film 1 10b, and two second metal layers 130b, which are disposed on the respective first metal layers 120b. The first metal layers 120b may be formed through electroless plating, and the second metal layers 130b may be formed through electroplating.

The dielectric film 110a or 110b may include a dielectric polymer material such as polyimide, polyester, or a liquid crystal polymer. The first metal layer 120a or the first metal layers 120b may include nickel, gold, chromium or copper.

The first metal layer 120a or the first metal layers 120b may be formed through electroless plating. Plating is classified into electroplating involving the use of a current or electroless plating not using a current. The first metal layer 120a or the first metal layers 120b may be formed through electroless plating, and the second metal layer 130a or the second metal layers 130b may be formed through electroplating.

More specifically, the first metal layer 120a or the first metal layers 120b may be formed on the dielectric film 110a or 110b as a seed layer. The first metal layer 120a or the first metal layers 120b may include nickel, copper, gold or chromium. Since gold is expensive and chromium has low electric conductivity, the first metal layer 120a or the first metal layers 120b may be formed of nickel or copper, which has a low resistance, so as to improve the efficiency of electroplating for forming the second metal layer 130a or the second metal layers 130b.

Examples of electroless plating, which is characterized by extracting metal ions contained in a plating solution as a metal through a reduction reaction caused by a reducing agent, include substitution plating and chemical reduction plating. The first metal layer 120a or the first metal layers 120b may be formed through chemical reduction plating by immersing the dielectric film 110a or 110b in an electroless plating solution containing nickel or copper ions and chemically extracting the nickel or copper ions from the electroless plating solution with the use of a reducing agent. The first metal layer 120a or the first metal layers 120b may be formed to a uniform thickness by placing the dielectric film 110a or 110b in uniform contact with the electroless plating solution.

The electroless plating solution may contain various components according to the type of metal used to form the first metal layer 120a or the first metal layers 120b. For example, the electroless plating solution may contain copper sulphate in order to form the first metal layer 120a or the first metal layers 120b of copper. The electroless plating solution may also include a polish and a stabilizer, thereby facilitating the storage and the recycle of the electroless plating solution.

The second metal layer 130a or the second metal layers 130b may be formed through electroplating. The second metal layer 130a or the second metal layers 130b may be formed of gold or copper, and particularly, copper, which is much cheaper than gold. More specifically, the second metal layer 130a or the second metal layers 130b may be formed by immersing the dielectric film 1 10a or 110b on which the first metal layer 120a or the first metal layers 120b are formed in an electroplating solution containing copper sulphate and applying a current to the electroplating solution so as to extract copper ions in the electroplating solution as copper.

Table 1 below shows the relationship between the ratio of the thickness of a metal layer to the thickness of a dielectric layer and the properties of a flexible film when the dielectric layer has a thickness of 38 µm.

**Table 1**

| Thickness of Metal Layer:Thickness of Dielectric Film | Flexibility | Peel Strength |
|---|---|---|
| 1:1.4 | × | ⊚ |
| 1:1.5 | ○ | ○ |
| 1:2 | ○ | ○ |
| 1:4 | ○ | ○ |
| 1:6 | ○ | ○ |
| 1:8 | ○ | ○ |
| 1:10 | ○ | ○ |
| 1:11 | ○ | × |
| 1:12 | ⊚ | × |
| 1:13 | ⊚ | × |

Referring to Table 1, electroless plating or electroplating may be performed so that the ratio of the sum of the thicknesses of the first metal layer 120a and the second metal layer 130a to the thickness of the dielectric film 110a can be within the range of 1:1.5 to 1:10. If the sum of the thicknesses of the first metal layer 120a and the second metal layer 130a is less than one tenth of the thickness of the dielectric film 110a, the peel strength of the first metal layer 120a and the second metal layer 130a may decrease, and thus, the first metal layer 120a and the second metal layer 130a may be easily detached from the dielectric film 110a or the stability of the dimension of circuit patterns may deteriorate.

On the other hand, if the sum of the thicknesses of the first metal layer 120a and the second metal layer 130a is greater than two thirds of the thickness of the dielectric film 110a, the flexibility of the flexible film 100a may deteriorate, or the time taken to perform plating may increase, thereby increasing the likelihood of the first and second metal layers 120a and 130a being damaged by a plating solution.

The dielectric film 110a may be formed to a thickness of 15-40 µm using a polyimide film. More specifically, the dielectric film 110a may be formed to a thickness of 35-38 µm. In this case, the first metal layer 120a and the second metal layer 130a may be formed to a thickness of 4-13 µm. This directly applies to a double-sided flexible film.

Table 2 below shows the relationship between the ratio of the thicknesses of first and second metal layers and the properties of a flexible film such as stability and peel strength when the second metal layer has a thickness of 8 µm.

**Table 2**

| Thickness of First Metal Layer:Thickness of Second Metal Layer | Stability | Peel Strength |
|---|---|---|
| 1:4 | ○ | × |
| 1:5 | ○ | ○ |
| 1:10 | ○ | ○ |
| 1:20 | ○ | ○ |
| 1:50 | ○ | ○ |
| 1:80 | ○ | ○ |
| 1:100 | ○ | ○ |
| 1:110 | ○ | ○ |
| 1:120 | ○ | ○ |
| 1:130 | × | ○ |
| 1:140 | × | ○ |

Referring to Table 2, the ratio of the thickness of the first metal layer 120a to the thickness of the second metal layer 130a may be 1:5 to 1:120. If the thickness of the first metal layer 120a is larger than one fifth of the thickness of the second metal layer 130a, the time taken to perform electroless plating for forming the first metal layer 120a may increase, and thus, the peel strength of the first metal layer 120a may deteriorate due to minor components of an electroless plating solution.

On the other hand, if the thickness of the first metal layer 120a is less than 1/120 of the thickness of the second metal layer 130a, a substitution reaction may occur between the first metal layer 120a and tin during the formation of a tin layer on circuit patterns of the flexible film 100a. When the sum of the thicknesses of the first metal layer 120a and the second metal layer 130a is 4-13 µm, the first metal layer 120a may have a thickness of 0.1 µm, and the second metal layer 130a may have a thickness of 8 µm. And this directly applies to a double-sided flexible film

Circuit patterns may be formed by etching the metal layer. In order to protect the circuit patterns, a protective film may be formed on the metal layer. The protective film may include a dielectric film that can protect the circuit patterns. For example, the protective film may include polyethylene terephthalate (PET).

An adhesive layer may be used to attach the protective film on the metal layer 120a or the metal layers 120b. The adhesive layer may include epoxy and may be formed to a thickness of 2-10 µm. If the adhesive layer has a thickness of less than 2 µm, the protective film may easily be detached from the flexible film 100a or 100b during the transportation or the storage of the flexible film 100a or 100b. If the adhesive layer has a thickness of more than 10 µm, the manufacturing cost of the flexible film 100a or 100b and the time taken to manufacture the flexible film 100a or 100b may increase, and it may be very difficult to remove the protective film.

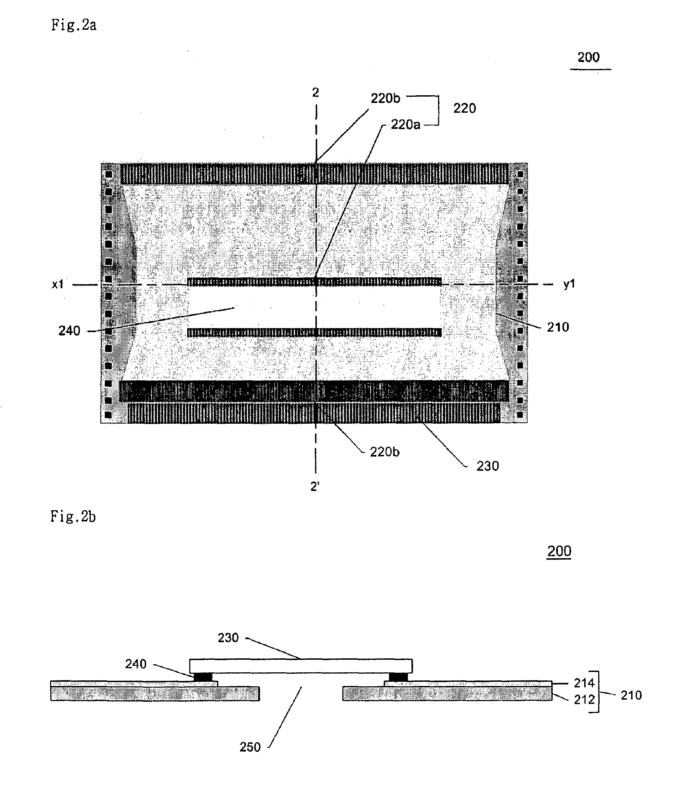

FIGS. 2A and 2B illustrate diagrams of a tape carrier package (TCP) 200 including a flexible film 210 according to an embodiment of the present invention. Referring to FIG. 2A, the TCP 200 includes the flexible film 210, circuit patterns 220, which are formed on the flexible film 210, and an integrated circuit (IC) chip 230.

The flexible film 210 includes a dielectric film and a metal layer, which is formed on the dielectric film.

The metal layer may include a first metal layer, which is formed on the dielectric film, and a second metal layer, which is formed on the first metal layer. The first metal layer may be formed through electroless plating, and the second metal layer may be formed through electroplating.

The first metal layer may include nickel, chromium, gold or copper. More specifically, the first metal layer may be formed of a highly-conductive metal such as nickel or copper in order to improve the efficiency of electroplating for forming the second metal layer.

Alternatively, the first metal layer may be formed through electroless plating by immersing the dielectric film in a copper sulphate-based electroless plating solution and extracting copper ions from the copper sulphate-based electroless plating solution as copper with the use of a reducing agent. A formaldehyde (HCHO)-series material may be used as the reducing agent.

The second metal layer may be formed by applying a current to a copper sulphate-based electroplating solution so as to extract copper ions as copper. The thickness of the second metal layer may be determined according to the amount of current applied. Once the second metal layer is formed, the circuit patterns 220 are formed by etching the first and second metal layers.

The circuit patterns 220 include inner leads 220a, which are connected to the IC chip 230, and outer leads 220b, which are connected to a driving unit or a panel of a display device. The pitch of the circuit patterns 220 may vary according to the resolution of a display device comprising the TCP 200. The inner leads 220a may have a pitch of about 30 µm, and the outer leads 220b may have a pitch of about 60 µm.

FIG. 2B illustrates a cross-sectional view taken along line 2-2' of FIG. 2A. Referring to FIG. 2B, the TCP 200 includes the flexible film 210, the IC chip 230, and gold bumps 240, which connect the flexible film 210 and the IC chip 230.

The flexible film 210 may include a dielectric film 212 and a metal layer 214, which is formed on the dielectric film 212. The dielectric film 212 is a base film of the flexible film 210 and may include a dielectric polymer material such as polyimide, polyester, or a liquid crystal polymer. In order to enhance the flexibility and the thermal resistance of the flexible film 210 and the stability of dimension of the circuit patterns 220 and provide sufficient peel strength with respect to the metal layer 214, the dielectric film 212 may be formed to a thickness of 15-40 µm, and particularly, 35-38 µm.

The metal layer 214 is a thin layer formed of a conductive metal such as nickel, chromium, gold or copper. The metal layer 214 may have a double-layer structure including first and second metal layers. The first metal layer may be formed of nickel, gold, chromium or copper through electroless plating, and the second metal layer may be formed of gold or copper through electroplating. In order to improve the efficiency of electroplating for forming the second metal layer, the first metal layer may be formed of nickel or copper.

The metal layer 214 may be formed to such a thickness that the ratio of the thickness of the metal layer 214 to the thickness of the dielectric film 212 can be 1:1.5-1:10. If the thickness of the metal layer 214 is less than one tenth of the thickness of the dielectric film 212, the stability of dimension of the circuit patterns 220 and the peel strength of the metal layer 214 may deteriorate. On the other hand, if the thickness of the metal layer 214 is larger than two thirds of the thickness of the dielectric film 212, the time taken to perform plating for forming the metal layer 212 may increase, thereby increasing the probability of the flexible film 210 being damaged by a plating solution.

The IC chip 230 is disposed on the flexible film 210 and is connected to the circuit patterns 220, which are formed by etching the metal layer 214. The flexible film 210 includes a device hole 250, which is formed in an area in which the IC chip 230 is disposed. After the formation of the device hole 250, flying leads are formed on the circuit patterns 220, to which the IC chip 230 is connected, and the gold bumps 240 on the IC chip 230 are connected to the flying leads, thereby completing the formation of the TCP 200. The flying leads may be plated with tin. The flying leads may be plated with tin. A gold-tin bond may be generated between the tin-plated flying leads and the gold bumps 240 by applying heat or ultrasonic waves.

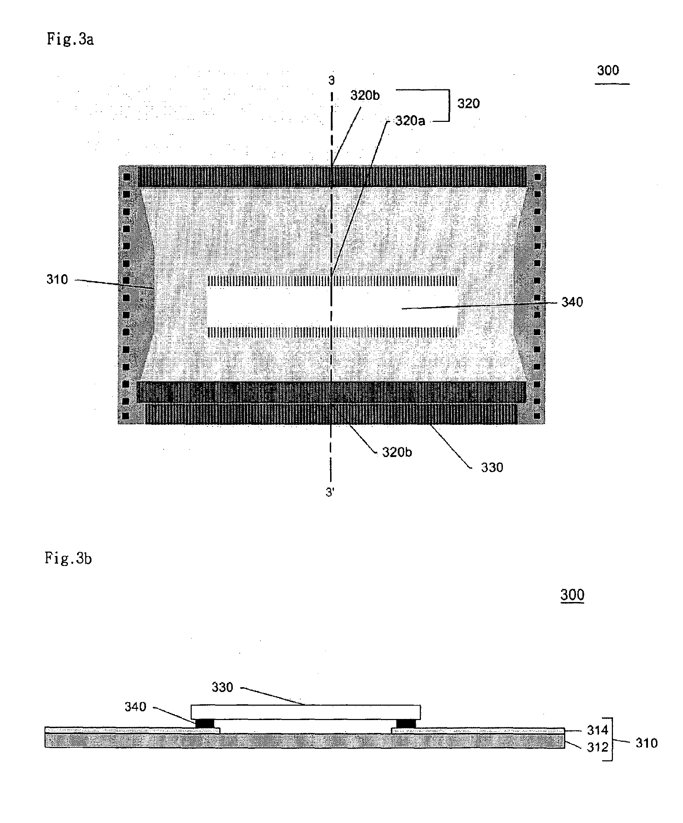

FIGS. 3A and 3B illustrate diagrams of a chip-on-film (COF) 300 including a flexible film 310 according to an embodiment of the present invention. Referring to FIG. 3A, the COF 300 includes the flexible film 310, circuit patterns 320, which are formed on the flexible film 310, and an IC chip 330, which is attached on the flexible film 310 and is connected to the circuit patterns 320.

The flexible film 310 may include a dielectric film and a metal layer, which is formed on the dielectric film. The circuit patterns 320 are formed by etching the metal layer. The circuit patterns 320 include inner leads 320a, which are connected to the IC chip 330, and outer leads 320b, which are connected to a driving unit or a panel of a display device. The outer leads 320b may be connected to a driving unit or a panel of a display device by anisotropic conductive films (ACFs).

More specifically, the outer leads 320b may be connected to a driving unit or a panel of a display device through outer lead bonding (OLB) pads, and the inner leads 320a may be connected to the IC chip 330 through inner lead bonding (ILB) pads. The IC chip 330 and the inner leads 320a may be connected by plating the inner leads 320a with tin and applying heat or ultrasonic waves to the tin-plated inner leads 320a so as to generate a gold-tin bond between the tin-plated inner leads 320a and gold bumps on the IC chip 330.

The ratio of the thickness of the metal layer to the thickness of the dielectric film may be 1:1.5 to 1:10. If the thickness of the metal layer is less than one tenth of the thickness of the dielectric film, the stability of dimension of the circuit patterns 320 and the peel strength of the metal layer may deteriorate. On the other hand, if the thickness of the metal layer is larger than two thirds of the thickness of the dielectric film, the time taken to perform plating for forming the metal layer may increase, thereby increasing the probability of the flexible film 310 being damaged by a plating solution.

The metal layer may have a double-layer structure including first and second metal layers. The first metal layer may be formed through electroless plating and may include nickel chromium, gold or copper. The second metal layer may be formed through electroplating and may include gold or copper. In order to improve the efficiency of electroplating for forming the second metal layer, the first metal layer may be formed of a metal having a low resistance such as copper or nickel.

The ratio of the thickness of the first metal layer to the thickness of the second metal layer may be 1:5 to 1:120 in order to improve the efficiency of electroplating for forming the second metal layer and prevent a substitution reaction between the circuit patterns 320 and a tin layer during the plating of the circuit patterns 320 with tin. More specifically, the first metal layer may have a thickness of about 0.1 µm, and the second metal layer may have a thickness of 4-13 µm.

FIG. 3B illustrates a cross-sectional view taken along line 3-3' of FIG. 3A. Referring to FIG. 3B, the COF 300 includes the flexible film 310, which includes a dielectric film 312 and a metal layer 314 formed on the dielectric film 312, the IC chip 330, which is connected to the circuit patterns 320 on the metal layer 314, and gold bumps 340, which connect the IC chip 330 and the circuit patterns 320.

The dielectric film 312 is a base film of the flexible film 310 and may include a dielectric material such as polyimide, polyester, or a liquid crystal polymer. More specifically, the dielectric film 312 may be formed of polyimide, which has excellent peel strength and thermal resistance. In order to improve the peel strength of the dielectric film 312 with respect to the metal layer 314 and the flexibility of the flexible film 310, the dielectric film 312 may be formed to a thickness of 15-40 µm.

The metal layer 314 is a thin layer formed of a conductive metal. The metal layer 314 may include a first metal layer, which is formed on the dielectric film 312, and a second metal layer, which is formed on the first metal layer. The first metal layer may be formed through electroless plating and may include nickel, chromium, gold or copper. The second metal layer may be formed through electroplating and may include gold or copper. The thickness of the metal layer 314 may account for one fifth to two thirds of the thickness of the dielectric film 312. If the thickness of the metal layer 314 is less than one fifth of the thickness of the dielectric film 312, the peel strength may deteriorate, and thus, the metal layer 314 may easily be detached from the dielectric film 312. In addition, the stability of dimension may also deteriorate, thereby making it difficult to form fine circuit patterns. On the other hand, if the thickness of the metal layer 314 is larger than two thirds of the thickness of the dielectric film 312, the flexibility of the flexible film 310 may deteriorate, and the probability of the flexible film 310 being damaged by a plating solution may increase.

The IC chip 330 is connected to the inner leads 320a of the circuit patterns 320 and transmits image signals provided by a driving unit of a display device to a panel of the display device. The pitch of the inner leads 320a may vary according to the resolution of a display device to which the COF 300 is connected. The inner leads 320a may have a pitch of about 30 µm. The IC chip 330 may be connected to the inner leads 320a through the gold bumps 340.

Referring to FIG. 3B, the COF 300, unlike the TCP 200, does not have any device hole 250. Therefore, the COF 300 does not require the use of flying leads and can thus achieve a fine pitch. In addition, the COF 300 is very flexible, and thus, there is no need to additionally form slits in the COF 300 in order to make the COF 300 flexible. Therefore, the efficiency of the manufacture of the COF 300 can be improved. For example, leads having a pitch of about 40 µm may be formed on the TCP 200, and leads having a pitch of about 30 to can be formed on the COF 300. Thus, the COF 300 is suitable for use in a display device having a high resolution.

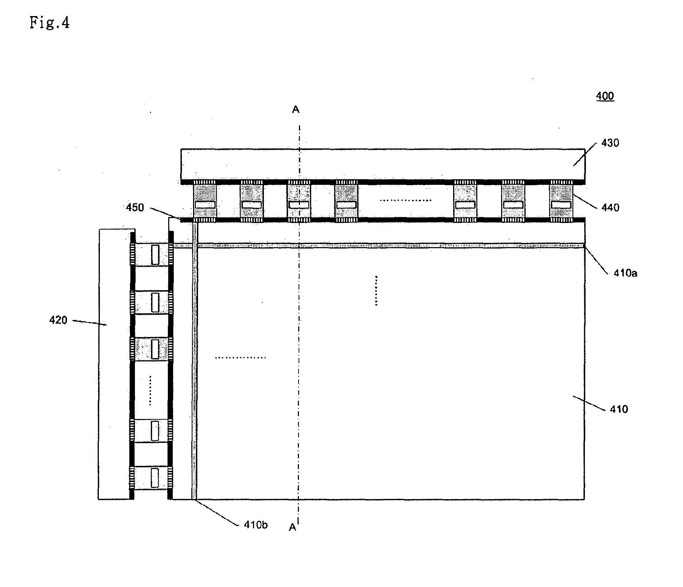

FIG. 4 illustrate diagram of a display device according to an embodiment of the present invention.

Referring to FIG. 4 the display device 400 according to an embodiment of the present invention may include a panel 410, which displays an image, a driving unit 420 and 430, which applies an image signal to the panel 410, a flexible film 440, which connects the panel 410 and the driving unit 420 and 430, and conductive films 450, which are used to attach the flexible film 440 to the panel 410 and to the driving unit 420 and 430. The display device 400 may be a flat panel display (FPD) such as a liquid crystal display (LCD), a plasma display panel (PDP) or an organic light-emitting device (OLED).

The panel 410 includes a plurality of pixels for displaying an image. A plurality of electrodes may be arranged on the panel 410 and may be connected to the driving unit 420 and 430. The pixels are disposed at the intersections among the electrodes. More specifically, the electrodes include a plurality of first electrodes 410a and a plurality of second electrodes 410b, which intersect the first electrodes 410a. The first electrodes 410a may be formed in row direction, and the second electrodes 410b may be formed in a column direction.

The driving units 420 and 430 may include a scan driver 420 and a data driver 430. The scan driver 420 may be connected to the first electrodes 410a, and the data driver 430 may be connected to the second electrodes 410b.

The scan driver 420 applies a scan signal to each of the first electrodes 410a and thus enables the data driver 430 to transmit a data signal to each of the second electrodes 410b. When the scan driver 420 applies a scan signal to each of the first electrodes 410a, a data signal can be applied to the first electrodes 410a, and an image can be displayed on the panel 400 according to a data signal transmitted by the data driver 430. Signals transmitted by the scan driver 420 and the data driver 430 may be applied to the panel 400 through the flexible films 440.

The flexible films 440 may have circuit patterns printed thereon. Each of the flexible films 440 may include a dielectric film, a metal layer, which is formed on the dielectric film, and an IC, which is connected to circuit patterns printed on the metal layer. Image signals applied by the driving units 420 and 430 may be transmitted to the first second electrodes 410a and the second electrodes 410b on the panel 410 through the circuit patterns and the IC of each of the flexible films 440. The flexible films 440 may be connected to the panel 410 and to the driving units 420 and 430 by the conductive films 450.

The conductive films 450 are adhesive thin films. The conductive films 450 may be disposed between the panel 410 and the flexible films 440, between the driving units 420 and 430 and the flexible films 440. The conductive films 450 may be anisotropic conductive films (ACFs).

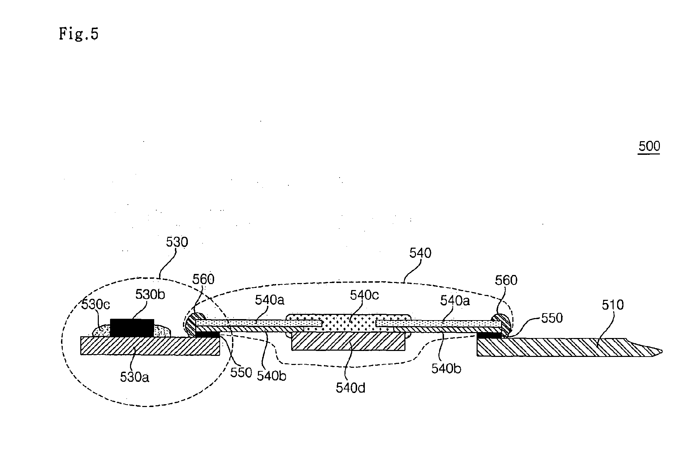

FIG. 5 is a cross-sectional view taken along line A-A' of the display device 400 in FIG. 4.

With reference to FIG. 5, the display device 500 comprises the panel 510 displaying an image, the data driver 530 that applies an image signal to the panel 510, the flexible film 540 connecting with the data driver 530 and the panel 510, and the conductive films 550 that electrically connects the flexible film 540 to the data driver 530 and the panel 510.

According to the embodiment of the present invention, the display device 500 may further comprise a resin 560 sealing up portions of the flexible film 540 contacting the conductive films 550. The resin 560 may comprise an insulating material and serve to prevent impurities that may be introduced into the portions where the flexible film 540 contacting the conductive films 550, to thus prevent damage of a signal line of the flexible film 540 connected with the panel 510 and the data driver 530, and lengthen a life span.

Although not shown, the panel 510 may comprise a plurality of scan electrodes disposed in the horizontal direction and a plurality of data electrodes disposed to cross the scan electrodes. The data electrodes disposed in the direction A-A' are connected with the flexible film 540 via the conductive film 550 as shown in FIG. 5 in order to receive an image signal applied from the data driver 530 and thus display a corresponding image.

The data driver 530 includes a driving IC 530b formed on a substrate 530a and a protection resin 530c for protecting the driving IC 530b. The protection resin 530c may be made of a material with insulating properties and protects a circuit pattern (not shown) formed on the substrate 530a and the driving IC 530b against impurities that may be introduced from the exterior. The driving IC 530b applies an image signal to the panel 510 via the flexible film 540 according to a control signal transmitted from a controller (not shown) of the display device 500.

The flexible film 540 disposed between the panel 510 and the data driver 530 includes polyimide film 540a, metal film 540b disposed on the polyimide films 540a, an IC 540c connected with a circuit pattern printed on the metal film 540b, and a resin protection layer 540d sealing up the circuit pattern and the IC 540c.

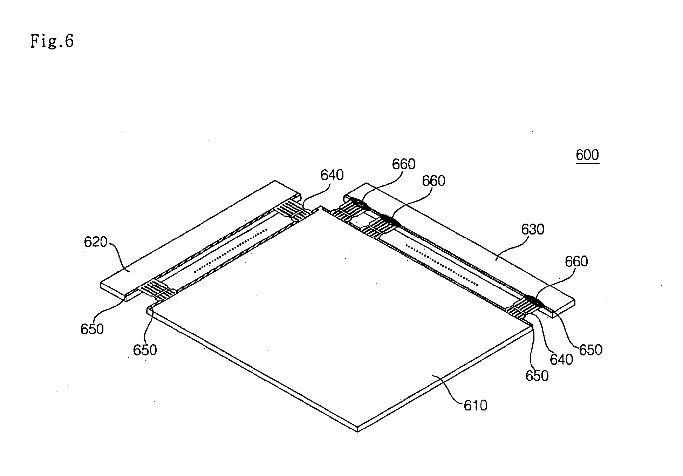

FIG. 6 illustrates diagram of a display device according to an embodiment of the present invention.
When the flexible films 640 are attached with the panel 610 and the driving units 620 and 630 through the conductive films 650, the flexible films 640 attached with the conductive films 650 can be sealed with the resin 660. With reference to FIG. 6e, because the portions of the flexible films 640 attached to the conductive films 650 can be sealed with the resin 660, impurities that may be introduced from the exterior can be blocked.

While the present invention has been particularly shown and described with reference to exemplary embodiments thereof, it will be understood by those of ordinary skill in the art that various changes in form and details may be made therein without departing from the spirit and scope of the present invention as defined by the following claims.

## Claims

1. A flexible film comprising:
a dielectric film; and
a metal layer disposed on the dielectric film,
wherein the ratio of the thickness of the metal layer to the thickness of the dielectric film is about 1:1.5 to 1:10.

2. The flexible film of claim 1, wherein the dielectric film comprises a polyimide film.

3. The flexible film of claim 1, wherein the metal layer comprises a first metal layer disposed on the dielectric film and a second metal layer disposed on the first metal layer.

4. The flexible film of claim 3, wherein the first metal layer comprises at least one of nickel, gold, chromium, and copper.

5. The flexible film of claim 3, wherein the second metal layer comprises at least one of gold and copper.

6. The flexible film of claim 3, wherein the ratio of the thickness of the first metal layer to the thickness of the second metal layer is about 1:5 to 1:120.

7. The flexible film of claim 3, wherein the metal layer further comprises circuit patterns printed thereon.

8. A flexible film comprising:
a dielectric film;
a metal layer electroless-plated on the dielectric film and including circuit patterns printed thereon; and
an integrated circuit (IC) chip disposed on the metal layer,
wherein the ratio of the thickness of the metal layer to the thickness of the dielectric film is about 1:1.5 to 1:10 and the IC chip is connected to the circuit patterns.

9. The flexible film of claim 8, further comprising a device hole formed in an area in which the IC chip is disposed.

10. The flexible film of claim 8, wherein the metal layer further comprises:
a first metal layer electroless-plated on the dielectric film; and
a second metal layer electro-plated on the first metal layer.

11. The flexible film of claim 10, wherein the ratio of the thickness of the first metal layer to the thickness of the second metal layer is about 1:5 to 1:120.

12. The flexible film of claim 8, further comprising gold bumps formed on the metal layer,
wherein the IC chip is connected to the circuit patterns through the gold bumps.

13. A display device comprising:
a panel;
a driving unit; and
a flexible film disposed between the panel and the driving unit;
wherein the flexible film comprises a dielectric film, a metal layer disposed on the dielectric film and having circuit patterns printed thereon, and an IC chip disposed on the metal layer and the ratio of the thickness of the metal layer to the thickness of the dielectric film is about 1:1.5 to 1:10.

14. The display device of claim 13, wherein the panel comprises:
a first electrode; and
a second electrode which intersects the first electrode,
wherein the first and second electrodes are connected to the circuit patterns.

15. The display device of claim 13, wherein the metal layer comprises a first metal layer disposed on the dielectric film and a second metal layer disposed on the first metal layer.

16. The display device of claim 15, wherein the ratio of the thickness of the first metal layer to the thickness of the second metal layer is about 1:5 to 1:120.

17. The display device of claim 13, further comprising a conductive film connecting at least one of the panel and the driving unit to the flexible film.

18. The display device of claim 17, wherein the conductive film is an anisotropic conductive film (ACF).

19. The display device of claim 13, further comprising a resin sealing up a portion of the flexible film contacting the conductive film.
